# EUROPEAN PATENT APPLICATION

(11) **EP 4 819 772 A1**
(43) Date of publication of application: **07.10.2026**
(21) Application number: 25194251.2
(22) Date of filing: 06.08.2025
(51) Int. Cl.: H05K 1/14

(54) **CIRCUIT BOARD, FUNCTIONAL COMPONENT MODULE AND ELECTRONIC DEVICE**

(30) Priority: 01.04.2025 TW 114112475
(71) Applicant: Giga-Byte Technology Co., Ltd., New Taipei City 231 (TW)
(72) Inventor: CHANG, Shih-Ho, 231 New Taipei City (TW); CHOU, Hui-Shan, 231 New Taipei City (TW)
(74) Representative: Becker, Eberhard

(57) **Abstract**

A circuit board (110), a functional component module (150), and an electronic device (100, 100') are provided. The circuit board (110) includes a substrate (112) and a support component (130). The support component (130), suitable for carrying functional components (120), includes a base plate (132) and multiple elastic elements (134), wherein the elastic elements (134) are disposed between the base plate (132) and the substrate (112) to provide supporting force to the base plate (132).

## Description

### BACKGROUND

### Technical Field

The present disclosure relates to a circuit board, a functional module, and an electronic device, and particularly relates to a circuit board, a functional module, and an electronic device adapted to different specifications of SSD.

### Related Art

In the conventional art, an additional base plate is provided in a thermal device of a solid-state drive (SSD) module to enhance a thermal conduction effect, and a thermal conductive adhesive is usually provided between the base plate and the solid-state drive module to increase a physical contact area, in order to achieve good thermal conduction effect.

However, not only is an overall dimension limited by the selection of the product (such as the solid-state drive module), but also when the solid-state drive module product is a double-sided specification (both front and back sides of the base plate are provided with SSD), the thickness dimension of the thermal conductive adhesive and/or the base plate must be adjusted to achieve good contact, thereby achieving an expected thermal conduction effect. At the same time, the thickness of the thermal conductive adhesive or the base plate must be adjusted again when changing to the solid-state drive module product with a single-sided (front)specification.

Therefore, the above-mentioned prior art has the following problems:

The design of the thermal base plate is easily limited by the design of the solid-state drive module product since different solid-state drive modules are provided with different thickness dimensions of base plates and thermal conductive adhesives.

When replacing the solid-state drive module, it is necessary to confirm whether a good contact area is formed between the base plate and thermal conductive adhesive with proper thickness dimensions. If the dimensions do not match, resulting in poor contact area, it is necessary to replace other appropriate base plate and thermal conductive adhesive separately, which not only increases the risk of disassembly and replacement of parts, but also easily causes damage risk due to the disassembly and assembly of screws during the disassembly process.

### SUMMARY

The present disclosure provides a circuit board that may adapt to different thickness and weight of functional modules disposed thereon.

The present disclosure provides a functional module that may adjust the distance between itself and the circuit board.

The present disclosure provides an electronic device adapted to different specifications of SSD.

A circuit board of the present disclosure includes a substrate and a support component. The support component adapted to carry a functional component includes a base plate and a plurality of elastic elements, wherein the elastic elements are disposed between the base plate and the substrate to provide supporting force to the base plate.

A functional component module of the present disclosure includes a functional component and a support component carrying the functional component. The support component includes a base plate and a plurality of elastic elements, wherein the elastic elements are disposed at a side of the base plate relatively away from the functional component.

An electronic device of the present disclosure includes a circuit board, a functional component, and a support component. The circuit board includes a substrate; the functional component is disposed on the substrate; the support component carrying the functional component includes a base plate and a plurality of elastic elements, wherein the elastic elements are disposed between the base plate and the substrate.

In an embodiment of the present disclosure, the support component further includes a plurality of guide posts, wherein the guide posts are disposed on a surface of one of the substrate and the base plate facing the other, and the guide posts are positioned in the corresponding elastic elements.

In an embodiment of the present disclosure, each of the elastic elements has an alignment hole, and the guide posts are adapted to be located in the corresponding alignment holes.

In an embodiment of the present disclosure, when the guide posts are disposed on the surface of the base plate facing the substrate, the substrate further provides with a plurality of through holes for the guide posts to be disposed and passed therethrough.

In an embodiment of the present disclosure, the elastic elements are sponges.

In an embodiment of the present disclosure, a hardness of the elastic elements ranges in 10-30 degrees.

In an embodiment of the present disclosure, a strength range of the elastic elements ranges in 0.25-0.4MPa.

In an embodiment of the present disclosure, a density of the elastic elements ranges in 0.1-0.2 g/cm³.

In an embodiment of the present disclosure, a plurality of electronic components are disposed on a single side of the functional component, or a plurality of the electronic components are respectively disposed on opposite sides of the functional component.

In an embodiment of the present disclosure, the electronic device further includes a thermal component disposed on a side of the functional component relatively away from the base plate.

In an embodiment of the present disclosure, the electronic device further includes a thermal pad disposed between the functional component and the thermal component.

Based on the above, through the configuration of the support component, the circuit board may adapt to functional components with different thicknesses and weights disposed thereon, and allows stepless adjustment of the distance between the functional component and the circuit board, thereby enabling the electronic device to have the convenience of being universally applicable to functional components with different thicknesses and weights.

### BRIEF DESCRIPTION OF THE DRAWINGS

FIG. 1A is an explosion diagram of an electronic device of a first embodiment.
FIG. 1B is an assembly diagram of the electronic device in FIG. 1A.
FIG. 2A is a diagram of the support component in FIG. 1.
FIG. 2B is a diagram of another view angle of FIG. 2A.
FIG. 3A is a diagram illustrating the support component first assembled to the substrate, and FIG. 3B is a diagram illustrating the support component first assembled with the functional component to form a functional component module.
FIG. 4 is an explosion diagram of the circuit board according to a second embodiment of the disclosure.
FIG. 5 is a diagram illustrating the guide post protruding from the bottom surface of the substrate.

### DESCRIPTION OF THE EMBODIMENTS

### First Embodiment

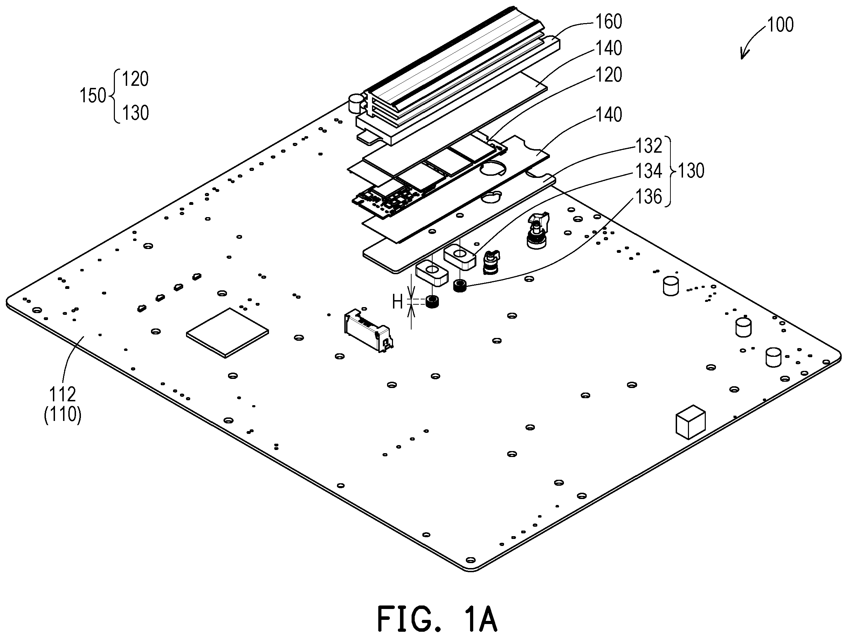

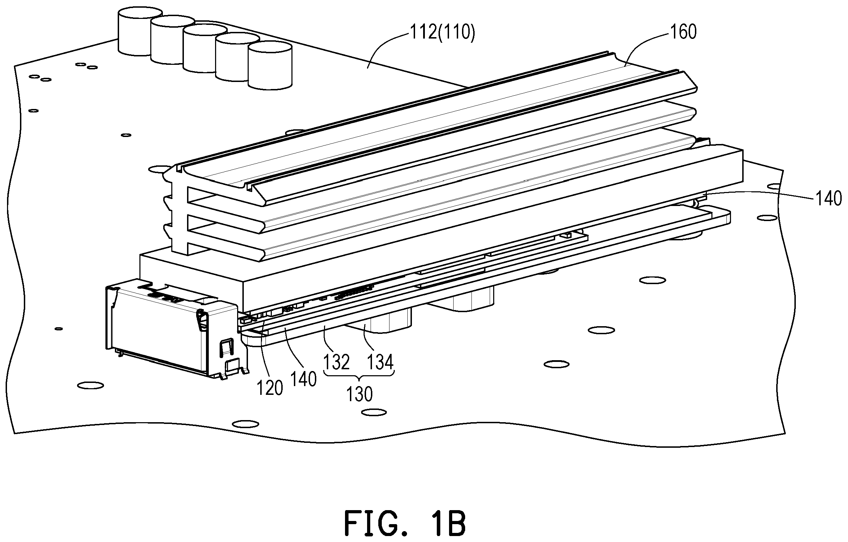

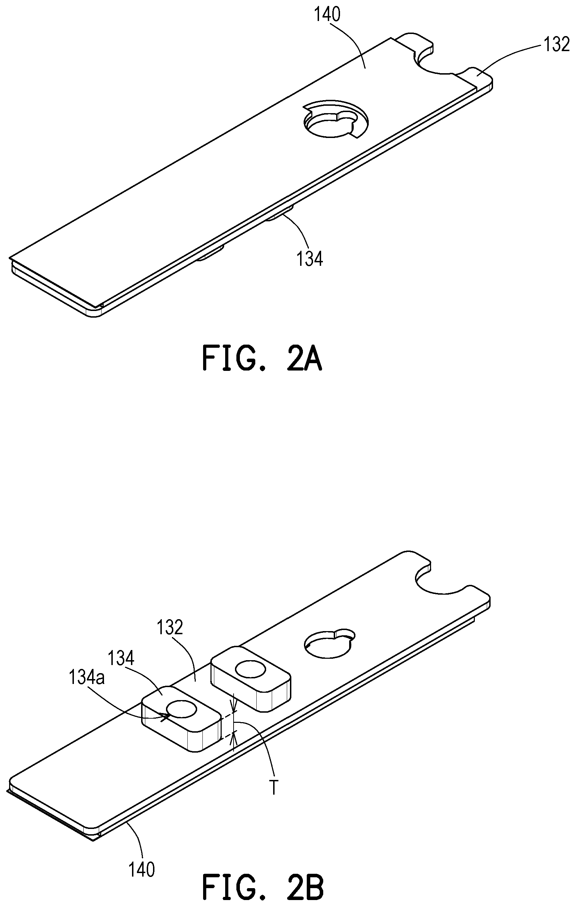

FIG. 1A is an explosion diagram of an electronic device of a first embodiment, and FIG. 1B is an assembly diagram of the electronic device in FIG. 1A. FIG. 2A is a diagram of the support component in FIG. 1, and FIG. 2B is a diagram of another view angle of FIG. 2A.

Please first refer to FIG. 1A and FIG. 1B, the electronic device 100 of this embodiment may be a computer or a server, wherein the electronic device 100 at least includes a circuit board 110, a functional component 120, and a support component 130.

Please refer to FIG. 1A, FIG. 2A and FIG. 2B simultaneously.

The circuit board 110 includes a substrate 112. The functional component 120 is disposed on the substrate 112.

Following the above, the functional component 120 of this embodiment is a solid-state drive module, but is not limited thereto. Specifically, the functional component 120 may be one selected from two specifications of solid-state drive modules, wherein one specification of the solid-state drive module is a solid-state drive module with multiple electronic components disposed on a single side (i.e., single-sided specification); and the other specification of the solid-state drive module is a solid-state drive module with multiple electronic components respectively disposed on both sides (i.e., double-sided specification), wherein the both sides refer to opposite sides. The user selects an appropriate specification of solid-state drive module to install on the support component 130 according to actual requirements.

The support component 130 is used to carry the functional component 120, wherein the support component 130 includes a base plate 132 and a plurality of elastic element 134 disposed between the base plate 132 and the substrate 112. The elastic elements 134 disposed between the base plate 132 and the substrate 112 are used to support the base plate 132 and the functional component 120 carried on the base plate 132.

The elastic elements 134 of this embodiment may be selected from sponge, foam, etc., and the elastic elements 134 may be disposed between the base plate 132 and the substrate 112 through adhesion method. The advantage of selecting sponge as the elastic elements 134 and using adhesion method to fix the elastic elements 134 to the base plate 132 and/or the substrate 112 is that: the positions of the elastic elements 134 corresponding to the base plate 132 or the substrate 112 are less restricted and have greater selection flexibility.

Specifically, compared to the conventional selection of spring as the elastic elements 134, where the spring needs to be positioned on the base plate 132 or the substrate 112 by means of fastening, and thus requires forming openings corresponding to screw fastening at the base plate 132 or the substrate 112, the positioning of the elastic elements 134 as a spring in the conventional technology is fixed and cannot be arbitrarily determined by the user.

In contrast, in this disclosure, by selecting sponge as the elastic elements 134 and using adhesion method to fix the elastic elements 134 to the base plate 132 and/or the substrate 112, even when the elastic elements 134 are disassembled for replacing different functional components 120, the elastic elements 134 may be adhered to the corresponding required position on the substrate 112 or the base plate 132 according to the needs.

The physical properties of the above-mentioned elastic elements 134 may comply with but are not limited to the following conditions: a hardness ranges in 10-30 degrees, a tensile strength ranges in 0.25-0.4MPa, and a density ranges in 0.1-0.2 g/cm³. The elastic elements 134 that meet the aforementioned physical property ranges are able to have sufficient strength to support the base plate 132 and the functional component 120 carried on the base plate 132, while also having sufficient deformation capability to compress in response to the weight of the components carried above, thereby enabling stepless adjustment of the distance between the functional component 120 and the substrate 112 through the deformation of the elastic elements 134, so that functional components 120 of different specifications may all be applied in the electronic device 100 of this embodiment.

Following the above, the support component 130 further includes a plurality of guide posts 136, wherein the elastic elements 134 of this embodiment are disposed together with the guide posts 136 on a surface of the substrate 112 facing the base plate 132, and each elastic element 134 has an alignment hole 134a, with the guide posts 136 positioned in the alignment hole 134a of the corresponding elastic elements 134, and through the cooperation of the guide posts 136 and the alignment holes 134a, displacement during the disposition of the elastic element 134 may be avoided. In this embodiment, a thickness T of the elastic element 134 is greater than a height H of the guide posts 136, and the disposition of the guide posts 136maintains a minimum spacing between the base plate 132 and the substrate 112 (i.e., the height H of the guide posts 136), to prevent the base plate 132 from impacting the substrate 112 or electronic components disposed on the substrate 112 and adjacent to the base plate 132 due to excessive compression of the elastic element 134.

Specifically, when the component installed on the base plate 132 is subjected to excessive force by the user, causing excessive pressure on the elastic element 134, the elastic element 134 may be over-compressed; at this time, the height H of the guide posts 136, which have no deformation capability, becomes greater than the thickness T of the over-compressed elastic element 134, and the guide posts 136 provide force to support the base plate 132, thus maintaining a minimum spacing between the base plate 132 and the substrate 112 that is at least equal to the height H of the guide posts 136, which can prevent the base plate 132 from impacting the substrate 112 or other electronic components disposed on the substrate 112 adjacent to the base plate 132.

To enhance the overall thermal dissipation effect of the electronic device 100, the electronic device 100 may further include a thermal component 160 disposed at a side of the functional component 120 relatively away from the base plate 132, this thermal component 160 may be a combination of a heat sink and heat fins. In other embodiments, the thermal component 160 may also be a heat sink, heat fins, fan, or a combination of any two or more of the heat sink, heat fins, and fan. The actual thermal component 160 is selected and disposed according to requirements.

Moreover, the electronic device 100 may further include a thermal pad 140, wherein the thermal pad 140 may be disposed between the functional component 120 and the thermal component 160 and/or between the functional component 120 and the base plate 132 as needed. The use of the thermal pad 140 may increase the contact area between the functional component 120 and the thermal component 160 and/or between the functional component 120 and the base plate 132, thereby enhancing the thermal conduction effect.

The above-mentioned thermal pad 140 may be formed from thermal conductive adhesive, or the thermal pad 140 may also be replaced with a heat sink, selected according to requirements.

Please refer to FIG.1A, FIG.1B and FIG.2B simultaneously, after the functional component 120, the support components 130, the thermal component 160, and the thermal pad 140 are assembled on the circuit board 110 to form the electronic device 100, a weight of the thermal component 160 and the functional component 120 together applies a downward force on the support components 130.

In the conventional technology, when the thermal component 160 is assembled above the functional component 120, the weight of the thermal component 160 may cause the circuit board 110 to bend, which in turn leads to solder cracking of the electronic components on the circuit board 110, preventing them from continuing to operate effectively.

In contrast, in this embodiment, when the functional component 120 and the thermal component 160 assembled on the functional component 120 apply a downward force on the elastic elements 134, the force is distributed to the elastic elements 134, causing the elastic elements 134 to compress and deform downward under the force; at the same time, the elastic element 134 also provides an upward elastic recovery force to push against the base plate 132, thereby offsetting part of the downward force applied to the circuit board 110 due to the weight of the functional component 120 and the thermal components 160. This effectively prevents the circuit board 110 from bending and avoid solder cracking.

In addition, the disposition of the elastic elements 134 enables the spacing between the base plate 132 and the circuit board 110 to be adjusted according to the thickness and weight of the functional component 120 carried thereon, therefore the electronic device 100 of this embodiment may be universally applicable to functional components 120 of different specifications.

Specifically, the functional component 120 is selected from one of the solid-state drive module with single-sided specification and the solid-state drive module with double-sided specification, wherein the thickness of the solid-state drive module with double-sided specification is thicker than the thickness of the solid-state drive module with single-sided specification; and the thickness difference between the solid-state drive module with double-sided specification and the solid-state drive module with single-sided specification may be eliminated by the degree of compression of the elastic element 134.

In detail, compared to a more compressed state of the elastic element 134 that the solid-state drive module with double-sided specification is assembled on the base plate 132, the elastic element 134 presents a more relaxed state when the solid-state drive module with single-sided specification is assembled on the base plate 132, wherein the deformation distance of the elastic element 134 from the relaxed to the compressed state is approximately 0.5mm to 2.5mm, preferably 1.5mm.

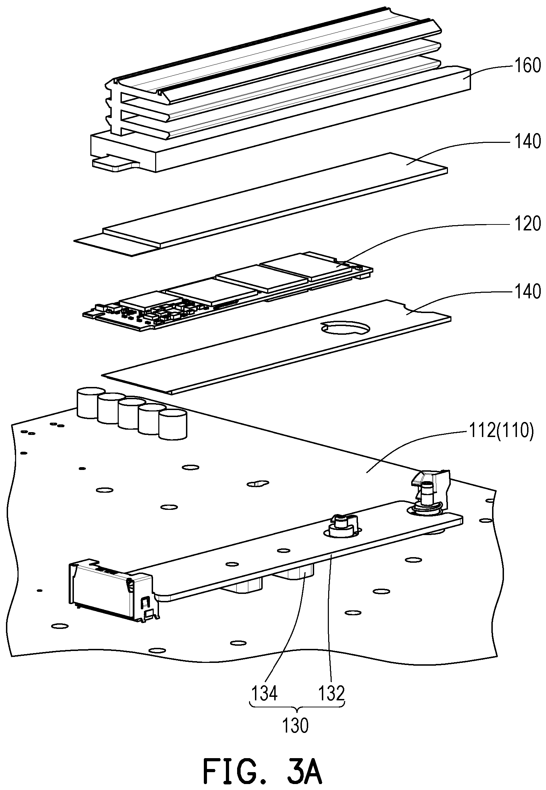

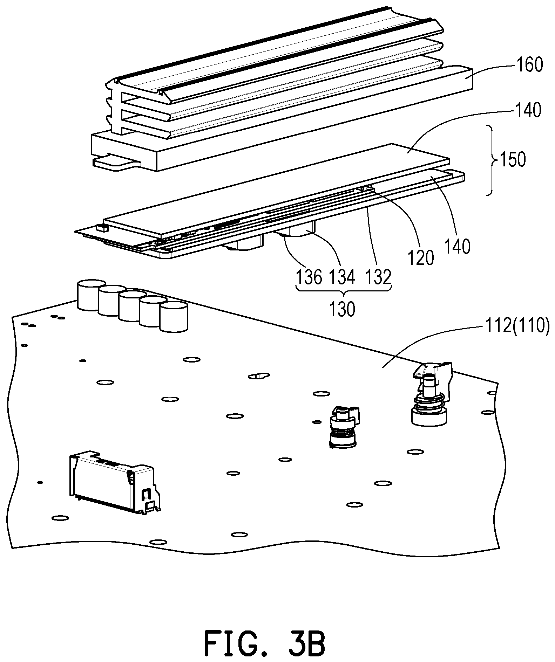

FIG. 3A is a diagram illustrating the support component first assembled to the substrate, and FIG. 3B is a diagram illustrating the support component first assembled with the functional component to form a functional component module.

Incidentally, the support component 130 in this embodiment may be pre-assembled to the substrate 112 of the circuit board 110, as shown in FIG. 3A, to facilitate the subsequent assembly of the functional component 120 to the base plate 132 of the support component 130. Alternatively, the support component 130 may also be pre-assembled together with the functional component 120 to form a functional component module 150, as shown in FIG.3B, to facilitate the subsequent assembly of the functional component module 150 to the circuit board 110.

### Second Embodiment

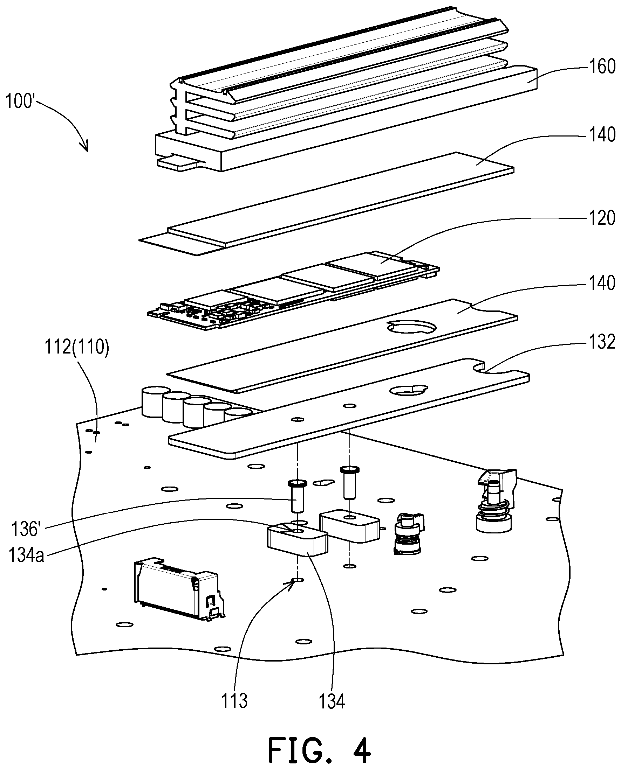

FIG. 4 is an explosion diagram of the circuit board according to a second embodiment of the disclosure. Referring to FIG.1A and FIG.4, this embodiment is substantially the same as the previous first embodiment, the difference between this embodiment and the previous first embodiment is that: in the electronic device 100' of this embodiment, a plurality of guide posts 136' pass through the base plate 132 from the surface of the base plate 132 facing the functional component 120 and are inserted into multiple through holes 113 disposed on the substrate 112 for the guide posts 136' to be disposed and passed therethrough.

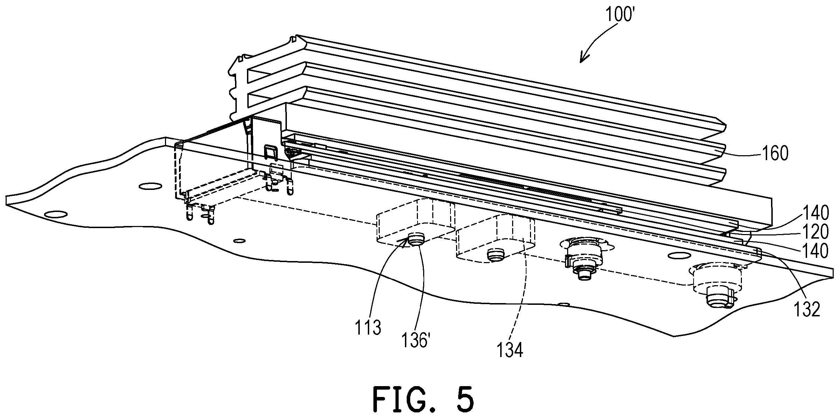

FIG. 5 is a diagram illustrating the guide post protruding from the bottom surface of the substrate. Referring to both FIG.4 and FIG.5, when the elastic elements 134 are compressed and deformed due to the weight of the functional component 120 and the thermal component 160 carried on the base plate 132, the base plate 132 thus moves toward the substrate 112, and at this time the guide posts 136' are driven by the base plate 132 to penetrate deeper into the through holes 113 of the substrate 112 and protrude more from the bottom surface of the substrate 112 relatively away from the elastic elements 134.

In this embodiment, the elastic elements 134 are disposed at positions corresponding to the through holes 113, and wherein the alignment holes 134a and the through holes 113 at least partially overlap, therefore the guide posts 136' pass through the alignment holes 134a of the elastic element 134 to be inserted into the through hole 113.

In another embodiment not illustrated, the elastic elements 134 may also be disposed offset from the through holes 113, the guide posts 136' do not need to pass through the elastic elements 134, and the guide posts 136' directly pass through the corresponding through holes 113.

From the above, it is known that in this configuration where the guide posts 136' passing through the base plate 132 from the surface of the base plate 132 facing the functional component 120 and being inserted into the through hole 113, the thickness difference between the double-sided specification solid-state drive module and the single-sided specification solid-state drive module is eliminated by the guide posts 136' protruding more from the bottom surface of the substrate 112, therefore there are more options for the disposition position of the elastic elements 134 that provide upward elastic recovery force to the base plate 132.

In summary, in the circuit board, the functional component module and the electronic device of the present disclosure, the support component not only provides good support effect, but also allows the circuit board to adapt to functional components with different thicknesses and weights disposed thereon, to steplessly adjust the distance between the functional component and the circuit board, thereby enabling the electronic device to have the convenience of being universally applicable to functional components with different thicknesses and weights.

In addition, the use of the thermal pad may increase the contact area between the base plate and the functional component and/or between the functional component and the thermal component, effectively improving the overall thermal conductivity efficiency of the electronic device.

## Claims

1. A circuit board (110), **characterized in that** the circuit board (110) comprising:
a substrate (112);
a support component (130), adapted to carry a functional component (120), comprising a base plate (132) and a plurality of elastic elements (134), wherein the elastic elements (134) are disposed between the base plate (132) and the substrate (112) to provide supporting force to the base plate (132).

2. The circuit board (110) according to claim 1, wherein the support component (130) further comprising a plurality of guide posts (136, 136'), disposed on a surface of one of the substrate (112) and the base plate (132) facing the other, and the guide posts (136, 136') are positioned in the corresponding elastic elements (134).

3. The circuit board (110) according to claim 1 or 2, wherein each of the elastic elements (134) has an alignment hole (134a), and the guide posts (136, 136') are adapted to be located in the corresponding alignment hole alignment holes (134a).

4. The circuit board (110) according to any one of claims 1 to 3, when the guide posts (136, 136') are disposed on the surface of the base plate (132) facing the substrate (112), the substrate (112) further provides with a plurality of through holes (113), for the guide posts (136, 136') to be disposed and passed therethrough.

5. The circuit board (110) according to any one of claims 1 to 4, wherein a strength of the elastic elements (134) ranges in 0.25~0.4MPa.

6. A functional component module (150), **characterized in that** the functional component module (150) comprising:
a functional component (120);
a support component (130), carrying the functional component (120), comprising a base plate (132) and a plurality of elastic elements (134), wherein the elastic elements (134) are disposed at a side of the base plate (132) relatively away from the functional component (120).

7. The functional component module (150) according to claim 6, wherein a strength of the elastic elements (134) ranges in 0.25-0.4MPa.

8. The functional component module (150) according to claim 6, wherein a single side of the functional component (120) is provided with a plurality of electronic components or both opposite sides of the functional component (120) are respectively provided with a plurality of the electronic components.

9. An electronic device (100, 100'), **characterized in that** the electronic device (100, 100') comprising:
a circuit board (110), comprising a substrate (112);
a functional component (120), disposed on the substrate (112); and
a support component (130), carrying the functional component (120), comprising a base plate (132) and a plurality of elastic elements (134), wherein the elastic elements (134) are disposed between the base plate (132) and the substrate (112).

10. The electronic device (100, 100') according to claim 9, wherein the support component (130) further comprising a plurality of guide posts (136, 136'), disposed on a surface of one of the substrate (112) and the base plate (132) facing the other, and the guide posts (136, 136') are positioned in the corresponding elastic elements (134).

11. The electronic device (100, 100') according to claim 9 or 10, wherein each of the elastic elements (134) has an alignment hole (134a), and the guide posts (136, 136') are adapted to be positioned in the corresponding alignment hole alignment holes (134a).

12. The electronic device (100, 100') according to any one of claims 9 to 11, when the guide posts (136, 136') are disposed on the surface of the base plate (132) facing the substrate (112), the substrate (112) further provides with a plurality of through holes (113) for the guide posts (136, 136') to be disposed and passed therethrough.

13. The electronic device (100, 100') according to any one of claims 9 to 12, wherein a single side of the functional component (120) is provided with a plurality of electronic components or both opposite sides of the functional component (120) are respectively provided with a plurality of the electronic components.

14. The electronic device (100, 100') according to any one of claims 9 to 13, further comprising a thermal component (160), disposed at a side of the functional component (120) relatively away from the base plate (132).

15. The electronic device (100, 100') according to any one of claims 9 to 14, further comprising a thermal pad, disposed between the functional component (120) and the thermal component (160).
